# EUROPEAN PATENT APPLICATION

(11) **EP 0 928 015 A2**
(43) Date of publication of application: **07.07.1999**
(21) Application number: 98124850.3
(22) Date of filing: 31.12.1998
(51) Int. Cl.: H01L 21/28, H01L 29/51

(54) **Method of preventing boron penetration**

(30) Priority: 31.12.1997 US 70227 P
(71) Applicant: TEXAS INSTRUMENTS INCORPORATED, Dallas, Texas 75265 (US)
(72) Inventor: NAG, Somnath S., Saratoga, CA 95070 (US); Grider, Douglas T., McKinney Texas 75070 (US)
(74) Representative: Holt, Michael

(57) **Abstract**

A high-density plasma process is used to deposit a high-density silicon nitride for use as a gate sidewall spacer (30). The low concentration of hydrogen in this material helps prevent boron diffusion across the gate oxide (15), promoting the use of boron-doped gates (20) in P-channel devices.

## Description

### Field of the Invention

The present invention relates generally to the field of integrated circuits, and more particularly to the integrated circuit structures and fabrication methods, and especially to producing a high quality silicon nitride film with a process which does not promote the diffusion of boron through the gate oxide.

### Background of the Invention

It has long been recognized that gates with P-type doping would help to provide work function equalization between gate and channel of PMOS transistors (See U.S. Patent 3,673,471 to Klein et al). However, a problem with this is that boron tends to diffuse into and through the gate oxide under the thermal cycling seen during processing, causing undesirable shifts in threshold voltage (See 2 Wolf, Silicon Processing for the VLSI Era 397-399 (1990)). A general discussion of the many factors affecting boron diffusion can be found in Fair and Gafiteanu, "Modeling boron diffusion in thin oxide p+ Si gate technology," 17 IEEE Electron Device Letters 497 (1996), and references therein cited which are hereby incorporated by reference.

It has become apparent through this work that the presence of hydrogen is one of the most significant factors which accelerates the undesirable diffusion of boron.

High quality silicon nitride films are required for front-end-of-the-line processes, such as gate sidewall spacers or for an etch-stop layer during a self-aligned contact (SACT) etch. The historical problem with deposited nitrides such as plasma-enhanced chemical vapor deposition (PECVD) nitride has been the higher concentration of hydrogen in the film, in the form of SiH and N-H. This excess hydrogen can result in an enhanced boron diffusion through thin gate dielectrics during subsequent thermal processing.

While low-pressure chemical vapor deposition (LPCVD) films may contain less hydrogen, the process requires relatively high temperatures (greater than 700 degrees C) in the presence of reactants such as SiH₂Cl₂ and NH₃. The hydrogen resulting from this reaction can also cause enhanced boron diffusion through the gate dielectric, resulting in a loss of Vt control of the transistor. Traditional LPCVD nitrides are found to have high H-concentrations, but even with low hydrogen concentration, the LPCVD process is extremely time-intensive. The hydrogen in the Si₃N₄ film is believed to assist in the boron-penetration problem, i.e., boron from the poly-silicon gate diffuses to the channel area. Traditional LPCVD nitride at about 800 degrees C has been found to cause severe boron penetration from gate poly to the channel region.

Integrated circuit processing with high-density-plasma ("HDP") is currently a very active area of research. The key difference between HDP conditions and the plasma conditions formerly used in integrated circuit processing is the ionization percentage: under HDP conditions the ratio of ions to neutral species near the surface of the wafer (outside the dark space) will typically be 10 percent or more, as compared to a much smaller ionization percentage in conventional plasma reactors. This higher ionization fraction is typically achieved by using an RF power input for ionization which is not applied directly to the wafer surface. In addition, a second RF power input is applied to the wafer surface (through the conductive susceptor which holds the wafer), to apply a voltage for ion bombardment (Note that the gas pressure under HDP conditions is not necessarily higher than in conventional plasma processing; indeed gas pressure under HDP conditions is often less than 100 milliTorr, since low pressures produce a longer mean free path and reduce recombination.)

The present application suggests a method of reducing the diffusion of boron through thin gate dielectrics by minimizing the presence of hydrogen and the thermal budget for nitride spacer formation. To achieve this, a high-density plasma (HDP) process is used to deposit a high-density silicon nitride film which will form the gate sidewall spacers. The deposition preferably place at a temperature below 550 degrees, and more preferably at 400 degrees C. The deposition preferably uses a source chemistry which does not include ammonia and which has an atomic ratio of N:H of at least 1:1, more preferably greater than 3:1, and more preferably still, greater than 6:1. This nitride film not only has relatively low hydrogen concentration, but also is a high-density matrix in which the diffusion of hydrogen and other dopants is slower than with conventional silicon nitride sidewall spacers, providing further protection against boron diffusion. Because of the dense nature of the film, the disclosed HDP nitride resists moisture and is harder to etch, making it an effective protective overcoat layer (PO), self-aligned contact (SACT) etch stop, and as a mask for shallow trench isolation (STI).

Advantages of the disclosed methods and structures include:
- promotes reduced diffusion of boron near nitride;
- reduced diffusion of dopants through nitride;
- provides a good moisture barrier;
- provides a good etch stop for oxides;
- provides a good CMP stop for oxides;
- process has high throughput;
- provides a low thermal budget for spacer deposition; and
- provides a low hydrogen spacer process to minimize boron diffusion during subsequent thermal processing.

### Brief Description of the Drawings

The present invention will now be further described, by way of example, with reference to certain exemplary embodiments illustrated in the accompanying drawings in which:
Figures 1A-1D are flowcharts of the use of HDP nitride in several embodiments;
Figures 2A-2D show the disclosed layer used in the processes of Figures 1A-1D;
Figure 3A graphically shows the threshold voltage shift versus the spacer split;
Figure 3B shows the threshold voltage versus the spacer split for nitride deposited by low-pressure chemical vapor deposition (at both 800 and 700 degrees C) and the disclosed high density plasma (HDP);
Figures 4A-C show the Fourier Transform IR Spectroscopy (FTIR) trace from Si₃N₄ films created respectively by three forms of Chemical Vapor Deposition (CVD): plasma enhanced (PE), Low Pressure (LP), and High Density Plasma (HDP) respectively.

### Detailed Description of the Preferred Embodiments

The numerous innovative teachings of the present application will be described with particular reference to the presently preferred embodiment. However, it should be understood that this class of embodiments provides only a few examples of the many advantageous uses of the innovative teachings herein. Moreover, some statements may apply to some inventive features but not to others.

The amount of hydrogen present in a Si₃N₄ film can be reduced by using a high-density plasma with a chemistry of nitrogen, silane (SiH₄) or disilane (Si₂H₆), and an inert gas, such as argon or helium. This is performed in a deposition environment where the simple precursor chemistry and the ion-bombardment during deposition causes the nitride film to be dense and less permeable to any impurities or moisture. Additionally, the ion-bombardment assists the hydrogen removal from the film, thereby reducing the amount of incorporated H and eliminating the SiH species. The temperature is lower than in previous depositions, preferably less than 550, and the atomic ratio of N:H in the input gases is preferably greater than 1:1, more preferably greater than 3:1, and more preferably greater than 6:1.

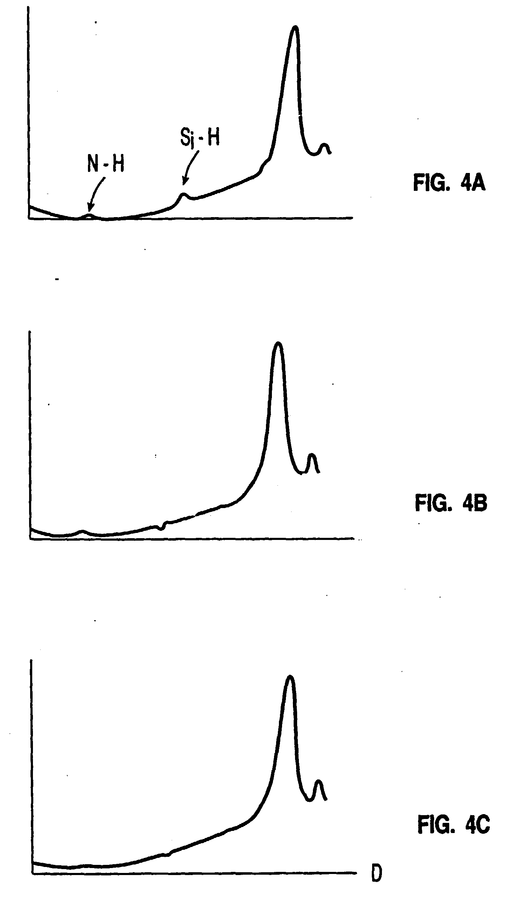

Figures 4A-C show a Fourier Transform IR Spectroscopy (FTIR) trace of Si₃N₄ films which have been produced respectively by plasma enhanced CVD (PECVD), Low Pressure CVD (LPCVD), and High Density Plasma (HDP-CVD) respectively. The film produced by HDP-CVD has practically no SiH compared to a film produced by PECVD and the N-H peak is smaller.

A recipe for the presently preferred embodiment follows, with ranges shown first, and preferred values in parenthesis:
Nitrogen Source Flow: 300-500 (410) sccm of N₂;
Silicon Source Flow: 20-40 (30) sccm of SiH₄;
Inert Flow: 200-400 (300) sccm of Ar;
Susceptor Temp: less than 550 (400) degrees C;
RF power: 2000-3000 (2250) Watts per square cm;
Bias RF 0-500 (0) Watts per square cm;
Helium Pressure: 0-2 (0 [no clamping voltage]) Torr;
Film Characteristics:
   Refractive Index: 1.995
   Stress: 290 megapascals compressive
   Deposition Rate: 110 nm/minute
   Non-Uniformity: less than 1.1 percent

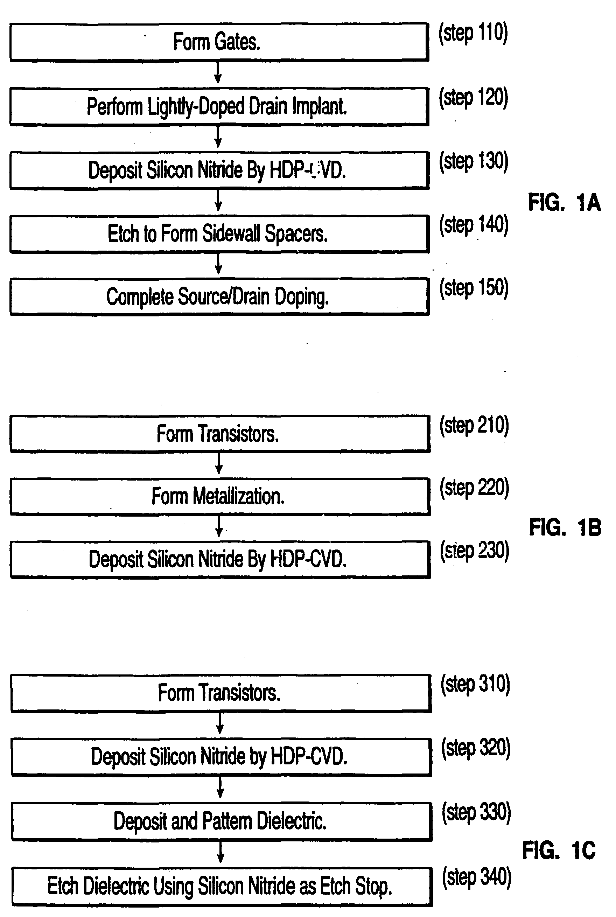

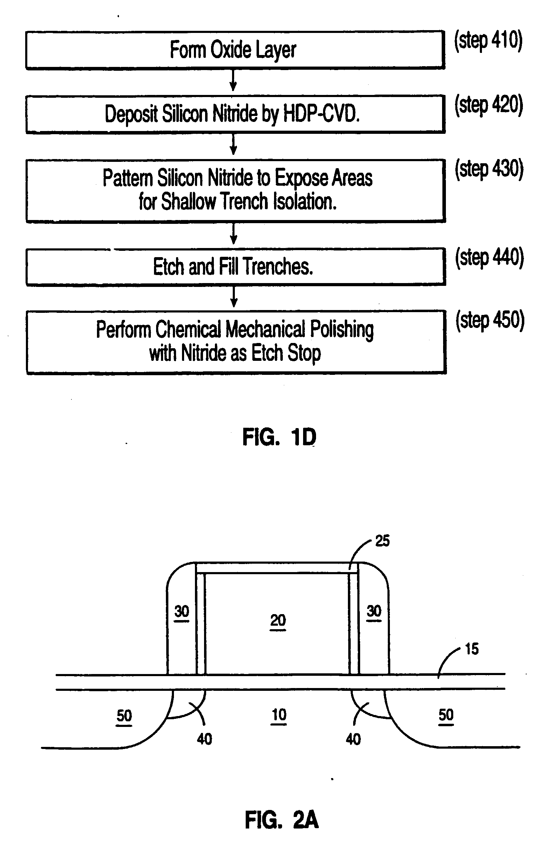

In the presently preferred embodiment, the disclosed silicon nitride film, which is formed by HDP-CVD, is used to form sidewall spacers on the gate of a MOS transistor. In this embodiment, seen in Figure 2A, with the flow seen in Figure 1A, an isolation structure is formed, generally either a thermally-grown field oxide or a dielectric-filled trench. This is followed by growth of a gate dielectric 15 (such as an oxide, oxynitride, a ON stack, etc.), deposition and patterning of the gate structure 20, and the growth/deposition of a "poly-smile" oxide 25 to repair any damage resulting from the gate etch. The gate may or may not be previously doped with an N-type dopant for NMOS or a P-type dopant for PMOS. Doping for the Lightly Doped Drain (LDD) 40 can be performed, if desired. At this point, a layer of HDP-CVD silicon nitride is deposited, to a thickness of, e.g., 100 nm, then anisotropically etched with a plasma etch to form sidewall spacers 30. Finally, source/drain doping can be completed, creating source/drain region 50, a dielectric deposited, and metallization created.

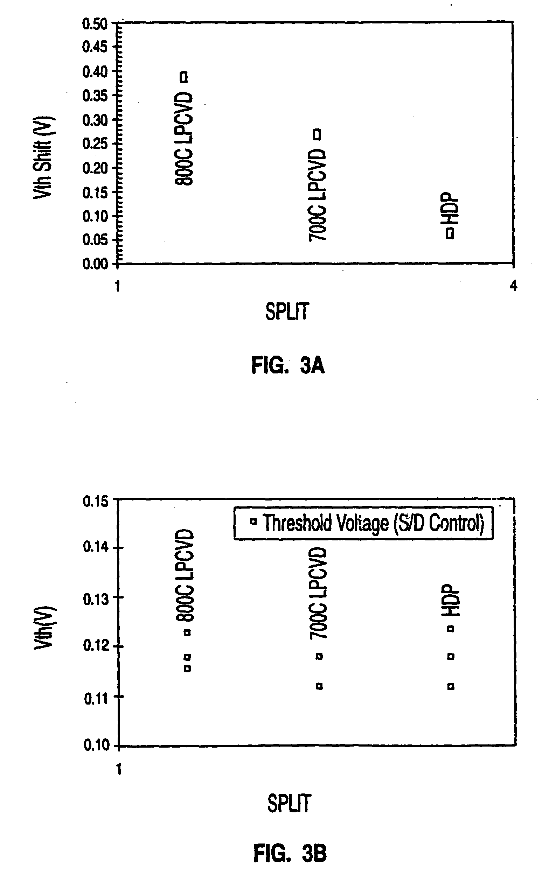

Figure 3A graphically shows the threshold voltage shift various test runs for nitride deposited by low-pressure chemical vapor deposition at both 800 and 700 degrees C (the higher temperature being preferred to maintain high throughput) and the disclosed high density plasma (HDP). Figure 3B shows the threshold voltage for films free of boron-penetration versus the spacer split for the same three nitrides, demonstrating no shift induced by the HDP process itself.

Silicon nitride deposited by HDP-CVD at about 400 degrees C reduces the boron penetration to a fourth that in film deposited by LPCVD. As shown in Figure 2A, the Vt shift from boron penetration is the smallest with the HDP-CVD silicon nitride.

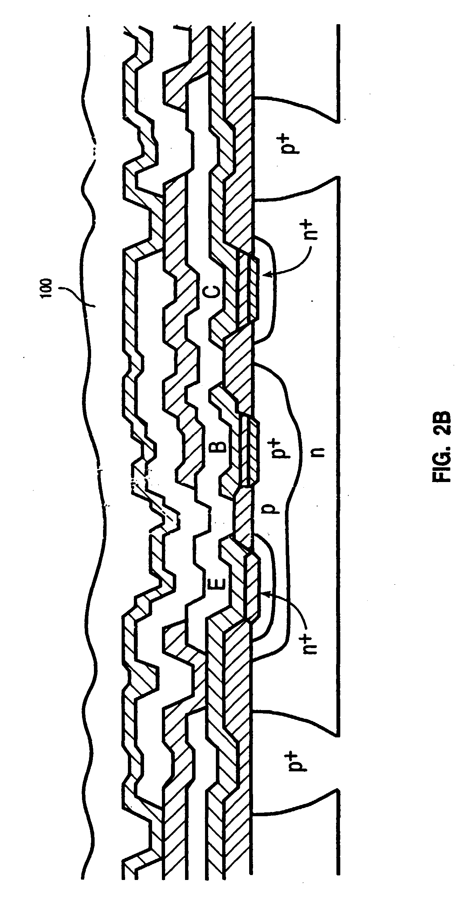

The dense nature of the HDP nitride film and the reduced SiH in the film make it a good moisture barrier. In an alternative embodiment, seen in Figure 2B, with the flow shown in Figure 1B, active devices will be created (step 210) and metallization formed (step 220). After the last metal layer is in place, HDP-CVD silicon nitride is deposited (step 130) to a thickness of 200-300 nm, to form a passivation overcoat 100 for the integrated circuit.

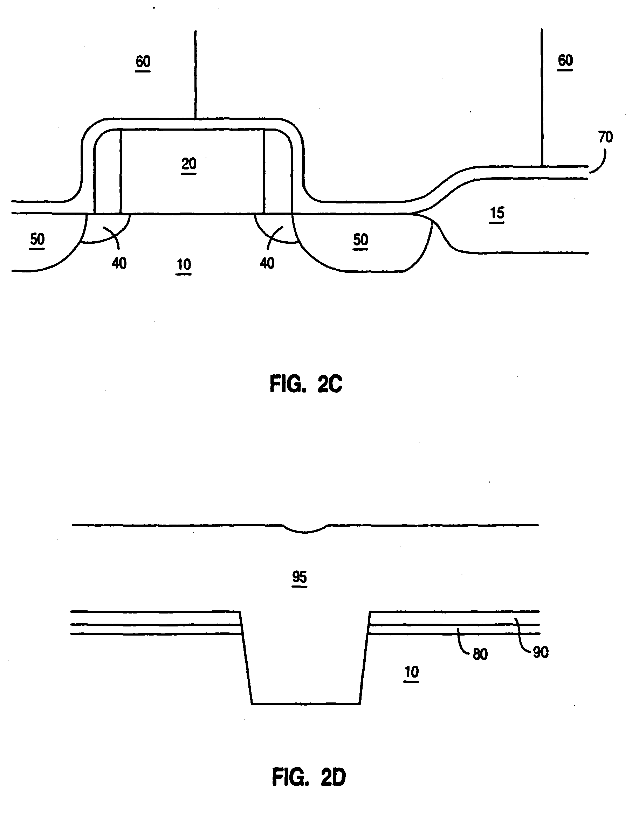

Advanced CMOS processes may now require contacts with little or no diffusion overlap. This means that contact may be drawn with edges coincident with the active field boundary. Misalignment from photolithography may result in a portion of the contact residing on the field region. During a self-aligned contact (SACT) etch, shown in Figure 2C the over-etch necessary to remove dielectric 60 can remove a thin layer of silicon from the substrate 10 and polysilicon gate 20, as well as oxide from the field oxide 15. In order to prevent this type of damage, an etch stop layer of HDP silicon nitride 70 can protect these vital areas. Figure 1C shows the flow for this embodiment, where after the formation of transistors (step 310), a 200-300 nm layer of silicon nitride 70 is deposited by HDP-CVD (step 320). A dielectric 60 is then deposited (step 330). When the dielectric is etched (step 340), layer 70 provides an excellent etch stop, preventing loss of field oxide and silicon from the active region. This ensures high source and drain integrity.

As shown in Figure 2D, the disclosed HDP nitride layer can be used as a CMP polish stop to protect the active areas during fabrication of shallow trench isolation. Figure 1D shows the flow for this embodiment, where the wafer is first covered (step 410) with a thin oxide layer 80, followed by deposition (step 420) of a 200-300 nm layer of HDP silicon nitride 90. This silicon nitride layer will be patterned and etched (step 430) to expose areas where isolation structures will be formed. Trenches are formed and over-filled (step 440) with a dielectric material 95, giving the structure seen in Figure 2D. This is followed by chemical mechanical polishing (CMP) (step 450) to planarize the wafer. The slurry is chosen to have a high degree of selectivity between the dielectric used in the trench and silicon nitride. The high density of the disclosed nitride layer provides an extra level of protection in this process.

According to a disclosed class of innovative embodiments, there is provided: A method for fabricating an integrated circuit, comprising the step of: depositing, by HDP-CVD, a layer containing silicon and nitride; wherein the atomic ratio of N:H in source gases used for said depositing step is at least 1:1; wherein said depositing step is performed with a susceptor temperature of less than 550 degrees C.

According to another disclosed class of innovative embodiments, there is provided: A method for fabricating an integrated circuit, comprising the step of: depositing, by HDP-CVD, a layer containing silicon and nitride; wherein the source gases used for said depositing step are N₂, an inert gas, and a gas chosen from the group of silane, disilane, or a combination of silane/disilane; wherein ammonia is not used as a source gas for said depositing step.

According to another disclosed class of innovative embodiments, there is provided: An integrated circuit, comprising: a plurality of N-channel field-effect transistors, ones of said N-channel transistors having a respective gate electrode portion which comprises a semiconductor material and which is doped N-type; a plurality of P-channel field-effect transistors, ones of said P-channel transistors having a respective gate electrode portion which comprises a semiconductor material and which is doped with at least one-tenth of one part per million of boron; said gates of ones of said P-channel transistors having sidewalls, and said sidewalls being at least partially coated by a material which comprises silicon and nitride and which has a low thermal budget and low hydrogen content.

According to another disclosed class of innovative embodiments, there is provided: An integrated circuit, comprising: a plurality of transistors formed in a substrate which comprises at least a block of semiconductor material; a layer of a dielectric formed over said plurality of transistors; a metallization layer which overlies said layer of dielectric and extends through said layer of dielectric to connect ones of said plurality of transistors; a passivation layer, comprising silicon and nitride, said passivation layer overlying said metallization layer and having a low thermal budget and low hydrogen content.

As will be recognized by those skilled in the art, the innovative concepts described in the present application can be modified and varied over a tremendous range of applications, and accordingly the scope of patented subject matter is not limited by any of the specific exemplary teachings given, but is only defined by the issued claims.

## Claims

1. A method of fabricating an integrated circuit comprising:
depositing a layer comprising silicon and a nitride using HDP-CVD, the atomic ratio of N:H in source gases used for said depositing step being at least 1:1;
performing said depositing step with a susceptor temperature of less than 550 degrees C.

2. The method of Claim 1, wherein said depositing step comprises depositing a layer of silicon and nitride using source gases having an atomic ratio that is greater than 3:1.

3. The method of Claim 1 or Claim 2, wherein said depositing step comprises depositing a layer of silicon and nitride using source gases having an atomic ratio that is greater than 6:1.

4. The method of any of Claims 1 to 3, wherein said step of performing said depositing step with a susceptor temperature of less than 550 degrees C comprises performing said depositing step with a susceptor temperature of approximately 400 degrees C.

5. The method of any of Claims 1 to 4, wherein the depositing step comprises depositing a layer comprising silicon and a nitride using source gases comprising N₂, an inert gas, and a gas chosen from a group comprising: silane, disilane, or a combination thereof.

6. The method of any of Claims 1 to 5, wherein the depositing step comprises depositing a layer comprising silicon and a nitride using source gases that do not include ammonia.

7. An integrated circuit comprising:
a plurality of N-channel field-effect transistors, at least one of said N-channel transistors having a respective gate electrode portion which comprises a semiconductor material and which is doped N-type;
a plurality of P-channel field-effect transistors, at least one of said P-channel transistors having a respective gate electrode portion which comprises a semiconductor material and which is doped with at least one-tenth of one part per million of boron;
said gates of said at least one P-channel transistors having sidewalls at least partially coated by a material which comprises silicon and nitride and which has a low thermal budget and low hydrogen content.

8. The integrated circuit of Claim 7, wherein the Vt shift of said p-channel transistors is less than the Vt shift of p-channel transistors having sidewalls coated with a material comprising silicon and nitride which has a higher thermal budget or higher hydrogen content.

9. An integrated circuit comprising:
a plurality of transistors formed in a substrate;
a layer of a dielectric formed over said plurality of transistors;
a metallization layer which overlies said layer of dielectric and extends through said layer of dielectric to connect at least one of said plurality of transistors;
a passivation layer comprising silicon and nitride overlying said metallization layer and having a low thermal budget and low hydrogen content.
